# EUROPÄISCHE PATENTANMELDUNG

(11) **EP 3 043 378 A2**
(43) Veröffentlichungstag der Anmeldung: **13.07.2016**
(21) Anmeldenummer: 15201506.1
(22) Anmeldetag: 30.08.2011
(51) Int. Cl.: H01L 21/60, B23K 20/02, H01L 23/488, B23K 20/233

(54) **VERFAHREN ZUM PERMANENTEN BONDEN VON WAFERN MITTELS FESTKÖRPERDIFFUSION ODER PHASENUMWANDLUNG MIT ANWENDUNG EINER FUNKTIONSSCHICHT**

(62) Teilanmeldung aus: 11749832.9
(71) Anmelder: EV Group E. Thallner GmbH, 4782 St. Florian am Inn (AT)
(72) Erfinder: MARTINSCHITZ, Klaus, 4782 St. Florian am Inn (AT); WIMPLINGER, Markus, 4910 Ried am Innkreis (AT); REBHAN, Bernhard, 4680 Haag a. H. (AT); HINGERL, Kurt, 4493 Wolfern (AT)
(74) Vertreter: Schneider, Sascha

(57) **Zusammenfassung**

Die vorliegende Erfindung betrifft ein Verfahren zum permanenten Bonden eines ersten Festkörpersubstrats (1) mit einem eine erste Materie (A) enthaltenden zweiten Festkörpersubstrat (2) mit folgendem Ablauf:

- Aufbringung und/oder Ausbildung einer eine zweite Materie (B) enthaltenden Funktionsschicht (5) auf das zweite Festkörpersubstrat (2), wobei die Funktionsschicht (5) vor der Ausbildung des permanenten Bonds eine mittlere Dicke (R) zwischen 0,1 nm und 25 nm aufweist,
- Kontaktieren des ersten Festkörpersubstrats (1) mit dem zweiten Festkörpersubstrat (2) an der Funktionsschicht (5),
- Zusammenpressen der Festkörpersubstrate (1, 2),
wobei nach dem Kontaktieren eine Reaktion (Festkörperdiffusion und/oder Phasenumwandlung) der zweiten Materie (B) mit der ersten Materie (A) derart erfolgt, dass durch Unebenheiten der Oberflächen der Festkörpersubstrate (1, 2) vorhandene Lücken verschlossen werden.

Während des Bondens wird die Löslichkeitsgrenze des ersten Materials (A) für das zweite Material (B) nicht oder nur geringfügig überschritten, so dass Ausscheidung von intermetallischen Phasen möglichst weitgehend vermieden wird und dagegen Mischkristall ausgebildet wird.

Das erste Material (A) kann Kupfer und das zweite Material (B) kann Zinn sein.

## Beschreibung

Die vorliegende Erfindung betrifft ein Verfahren zum Bonden eines ersten Festkörpersubstrats, insbesondere Halbleiterwafer, mit einem zweiten Festkörpersubstrat, insbesondere Halbleiterwafer, gemäß Patentanspruch 1.

Ziel beim permanenten oder irreversiblen Bonden von Festkörpersubstraten ist es, zwischen den beiden Kontaktflächen der Festkörpersubstrate eine möglichst starke und insbesondere unwiderrufliche Verbindung, also eine hohe Bondkraft, zu erzeugen. Hierfür existieren im Stand der Technik verschiedene Ansätze und Herstellungsverfahren, insbesondere das Verschweißen der Oberflächen bei höheren Temperaturen.

Permanent verbondet werden alle Arten von Materialien, vorwiegend allerdings Metalle und/oder Keramiken. Eine der wichtigsten Systeme des Permanentbondens sind Metall-Metall Systeme. Vor allem in den letzten Jahren traten die Cu-Cu Systeme vermehrt in Erscheinung. Die Entwicklung von 3D Strukturen verlangt nämlich meistens die Verbindung unterschiedlicher funktionaler Schichten. Diese Verbindung wird immer häufiger über sogenannte TSVs (Through Silicon Vias) realisiert. Die Kontaktierung dieser TSVs zueinander erfolgt sehr oft durch Kupferkontaktstellen. Zum Zeitpunkt des Bondens liegen sehr oft bereits vollwertige, funktionstüchtige Strukturen, beispielsweise Mikrochips, an einer oder mehreren Oberflächen der Festkörpersubstrate vor. Da in den Mikrochips unterschiedliche Materialien mit unterschiedlichen thermischen Ausdehnungskoeffizienten verwendet werden, ist eine Erhöhung der Temperatur beim Bonden unerwünscht. Diese kann zu thermischen Dehnungen und damit zu Thermospannungen führen, die Teile des Mikrochips oder seiner Umgebung zerstören können.

Die bekannten Herstellungsverfahren und bisher verfolgten Ansätze führen häufig zu nicht oder schlecht reproduzierbaren und insbesondere kaum auf veränderte Bedingungen übertragbaren Ergebnissen. Insbesondere benutzen derzeit eingesetzte Herstellungsverfahren häufig hohe Temperaturen, insbesondere >400°C, um wiederholbare Ergebnisse zu gewährleisten.

Technische Probleme wie hoher Energieverbrauch und eine mögliche Zerstörung von auf den Festkörpersubstraten vorhandenen Strukturen resultieren aus den bisher für eine hohe Bondkraft erforderlichen hohen Temperaturen von teilweise weit über 300°C.

Weitere Anforderungen bestehen in:
- der Front-end-of-line-Kompatibilität.
   Darunter versteht man die Kompatibilität des Prozesses während der Herstellung der elektrisch aktiven Bauteile. Der Bondingprozess muss also so ausgelegt werden, dass aktive Bauelemente wie Transistoren, die bereits auf den Strukturwafern vorhanden sind, während der Prozessierung weder beeinträchtigt noch geschädigt werden. Zu den Kompatibilitätskriterien zählen vor allem die Reinheit an gewissen chemischen Elementen (vor allem bei CMOS Strukturen), mechanische Belastbarkeit, vor allem durch Thermospannungen.
- niedrige Kontamination.
- keine, oder möglichst niedrige, Krafteinbringung.
- möglichst niedrige Temperatur, insbesondere bei Materialien mit unterschiedlichem Wärmeausdehnungskoeffizienten.

Die Reduktion der Bondkraft führt zu einer schonenderen Behandlung der Strukturwafer, und damit zu einer Reduktion der Ausfallwahrscheinlichkeit durch direkte mechanische Belastung, insbesondere wenn die Isolationslagen zwischen den metallischen Leitern aus sogenannten "low-k" Materialen gefertigt sind.

Das Verschweißen zweier Oberflächen funktioniert umso besser, je ebener die Oberflächen sind, je weniger Kontaminationen sich auf den Oberflächen befinden und je perfekter deren Oberflächenstruktur ist. In der Realität hat man es allerdings mit Oberflächen zu tun, die durch Wasser, organische Substanzen, Partikel und ähnliches verunreinigt sind, die eine nicht vernachlässigbare Oberflächenrauhigkeit besitzen und sehr oft mehr oder weniger stark oxidiert sind. Die Entfernung der Partikel erfolgt in der Industrie durch unterschiedliche Prozesse, meist in mehreren voneinander unabhängigen Modulen. Die Entfernung der Oxide ist sicherlich eine der schwierigsten Herausforderungen, sind doch gerade Metalloxide chemisch relativ stabil. Selbst wenn man alle adhäsiven Substanzen und chemisch erzeugten Produkte von der Metalloberfläche entfernt, existiert immer noch die raue Oberfläche als letztes Hindernis für einen perfekten Bond.

Heutige Bondingverfahren sind vor allem auf hohe Drücke und Temperaturen ausgelegt. Vor allem das Vermeiden einer hohen Temperatur ist von essentieller Bedeutung für das Verschweißen zukünftiger Halbleiteranwendungen, da unterschiedliche Materialien mit unterschiedlichen thermischen Ausdehnungskoeffizienten nicht zu vernachlässigende thermische Spannungen bei Aufheiz- und/oder Abkühlvorgängen erzeugen. Des Weiteren wird die Diffusion von Dotierungselementen bei steigender Temperatur zunehmend zum Problem. Die dotierten Elemente sollen nach dem Dotiervorgang das vorgesehene Raumgebiet nicht verlassen. Anderenfalls würden sich die physikalischen Eigenschaften der Schaltkreise fundamental ändern. Dies führt im besten Fall zu einer Verschlechterung, im schlimmsten und wahrscheinlichsten Fall zur Funktionsuntüchtigkeit des Bauteils. Vor allem Speicher sind durch Ihre hohe Transistorendichte und Ihre hohe Dotierungsdichte anfällig für hohe Temperaturen. Andererseits sind es gerade die Speicher, bei denen die 3D Technologie zunehmend zur Kapazitäts- und Leistungssteigerung verwendet wird.

Das Problem beim heutigen Stand der Technik besteht, nach der Dekontaminierung der Oberfläche, darin, eine möglichst plane Oberfläche zu schaffen. Dies wird ansatzweise durch Schleifprozesse ermöglicht. Schleifprozesse sind allerdings nicht in der Lage, die Oberfläche perfekt zu planarisieren. Ein weiterer Arbeitsschritt wäre das Polieren. Dabei werden Werkzeuge mit speziellen Oberflächen verwendet, welche die Metalloberflächenrauhigkeit weiter reduzieren. Durch eine Kombination von Schleifen und Polieren werden Rauhigkeiten im Nanometer, manchmal sogar Subnanometer Bereich erzeugt. In den meisten Fällen werden sogenannte CMP Methoden verwendet. Dabei handelt es sich um einen chemischmechanischen Polierprozess. Unabhängig davon, wie lange oder wie genau man schleift, erhält man immer eine Restrauhigkeit, die nicht eliminiert werden kann. Diese Restrauhigkeit führt beim Kontakt zweier Oberflächen immer zur Bildung von Poren im Nano- bzw. Subnanometerbereich.

Aufgabe der vorliegenden Erfindung ist es daher, ein Verfahren zur schonenden Herstellung eines permanenten Bonds zwischen zwei Festkörpersubstraten mit einer möglichst hohen Bondkraft bei gleichzeitig möglichst niedriger Temperatur anzugeben.

Diese Aufgabe wird mit den Merkmalen des Patentanspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, zumindest an einem der Festkörpersubstrate eine Funktionsschicht mit einer ersten Materie zu schaffen beziehungsweise aufzubringen, die, insbesondere nach der Kontaktierung beziehungsweise Herstellung eines Prebonds zwischen den Festkörpersubstraten, mit einer zweiten Materie, die in dem anderen Festkörpersubstrat, zu reagieren und dadurch einen irreversiblen beziehungsweise permanenten Bond zwischen den Festkörpersubstraten auszubilden. Die beiden Festkörpersubstrate müssen nicht notwendigerweise einen Prebond miteinander eingehen. Auch eine einfache Kontaktierung ohne Ausbildung eines Prebonds ist möglich. Als "Reaktion" ist erfindungsgemäß eine Festkörperdiffusion und/oder eine Phasenumwandlung vorgesehen. Vor und/oder nach der Ausbildung/Aufbringung der Funktionsschicht auf dem ersten und/oder zweiten Festkörpersubstrat findet meist eine Reinigung des Festkörpersubstrats oder der Festkörpersubstrate statt, insbesondere durch einen Spülschritt. Diese Reinigung soll zumeist sicherstellen, dass sich keine Partikel auf den Oberflächen befinden, die ungebondete Stellen zur Folge haben würden.

Durch die Funktionsschicht und die in der Funktionsschicht enthaltene Materie wird eine technische Möglichkeit geschaffen, unmittelbar an den Kontaktflächen zwischen den Festkörpersubstraten nach der Herstellung des vorläufigen beziehungsweise reversiblen Bonds gezielt eine den permanenten Bond verstärkende und die Bondgeschwindigkeit erhöhende Reaktion (erste Materie mit der zweiten Materie) zu induzieren, wobei, insbesondere durch Verformung mindestens einer der Kontaktflächen (vorzugsweise die durch die Funktionsschicht gebildete Kontaktfläche) durch die Reaktion, auf Grund von Unebenheiten der Oberflächen/Kontaktflächen vorhandene Lücken geschlossen werden, insbesondere in Verbindung mit einem Zusammenpressen durch Druckbeaufschlagung der Festkörpersubstrate gegeneinander. Unter Verformung ist eine Volumenausdehnung im Allgemeinen, eine Phasenumwandlung oder Plastifizierung zu verstehen, die zu einer Formänderung der Kristallite und/oder amorphen Bereiche der Oberfläche führt.

Als erfindungsgemäße Festkörpersubstrate sind solche Festkörpersubstrate geeignet, deren Material in der Lage ist, als Materie mit einer weiteren, zugeführten Materie zu einer Mischmaterie mit einem höheren molaren Volumen zu reagieren beziehungsweise sich zu vermischen, wodurch ein Wachstum an der Funktionsschicht bewirkt wird, und zwar insbesondere an Lücken bildenden Minima der Oberflächen der Festkörpersubstrate. Besonders vorteilhaft sind die nachfolgenden Kombinationen von Materien, entweder wegen der Möglichkeit Mischkristalle zu bilden, sich gut plastisch zu verformen, Phasenumwandlungen zu durchlaufen, die zu einer Volumenzunahme führen, oder wegen jeder anderen, in der Beschreibung genannten direkten oder indirekten Methode die Lücken im Bondinterface zu schließen:
- Cu-Fe, Cu-Ge, Cu-In, Cu-Li, Cu-Mg, Cu-Mn, Cu-Nb, Cu-Nd, Cu-Ni, Cu-Si, Cu-Sn, Cu-Zn, Cu-Zr, Cu-Ti, Cu-W, Cu-Ti, Cu-Ta, Cu-Au, Cu-Al, Cu-Cu
- W-Fe, W-Ge, W-In, W-Li, W-Mg, W-Mn, W-Nb, W-Nd, W-Ni, W-Si, W-Sn, W-Zn, W-Zr, W-Ti, W-Ti, W-Ta, W-Au, W-Al
- Ti-Fe, Ti-Ge, Ti-In, Ti-Li, Ti-Mg, Ti-Mn, Ti-Nb, Ti-Nd, Ti-Ni, Ti-Si, Ti-Sn, Ti-Zn, Ti-Zr, Ti-Ta, Ti-Au, Ti-Al
- Ta-Fe, Ta-Ge, Ta-In, Ta-Li, Ta-Mg, Ta-Mn, Ta-Nb, Ta-Nd, Ta-Ni, Ta-Si, Ta-Sn, Ta-Zn, Ta-Zr, Ta-Ti, Ta-W, Ta-Ti, Ta-Ta, Ta-Au, Ta-Al
- Au-Fe, Au-Ge, Au-In, Au-Li, Au-Mg, Au-Mn, Au-Nb, Au-Nd, Au-Ni, Au-Si, Au-Sn, Au-Zn, Au-Zr, Au-Ti, Au-W, Au-Ti, Au-Au, Au-Au, Au-Al
- Al-Fe, Al-Ge, Al-In, Al-Li, Al-Mg, Al-Mn, Al-Nb, Al-Nd, Al-Ni, Al-Si, Al-Sn, Al-Zn, Al-Zr, Al-Ti, Al-W, Al-Ti, Al-Al, Al-Al, Al-Al

Als Festkörpersubstrate sind außerdem folgende Mischformen von Halbleitern denkbar:
- III-V: GaP, GaAs, InP, InSb, InAs, GaSb, GaN, AlN, InN, AlₓGa₁₋ₓAs, InₓGa₁₋ₓN
- IV-IV: SiC, SiGe,
- III-VI: InAlP.
- nichtlineare Optik: LiNbO₃, LiTaO₃, KDP (KH₂PO₄)
- Solarzellen: CdS, CdSe, CdTe, CuInSe₂, CuInGaSe₂, CuInS₂, CuInGaS₂
- Leitende Oxide: In₂₋ₓSnxO_{3-y}

Obwohl die oben genannten binären, tertiären und quartären Phasensysteme meistens extrem geringe Randlöslichkeiten besitzen, sich auf Grund ihrer kovalenten Bindungsaffinität eher spröde verhalten, meistens als Einkristalle und nur sehr selten als Polykristalle vorkommen, könnten die für Metalle erfindungsgemäß beanspruchten Eigenschaften auch in Halbleitersystemen vorkommen. Man beachte, dass die Oberflächenrauhigkeiten heutiger Halbleiterwafer so weit reduziert werden kann, dass die erfindungsgemäß zu schließenden Lücken nur ein Volumen im Angströmbereich haben können. Es ist Fakt, dass selbst bei schlechter Randlöslichkeit eines Mehrkomponentensystems sich Komponenten in der Hauptkomponente lösen können, wenn auch nur im ppm Bereich. Daher werden und sollen die erfindungsgemäßen Gedanken auch für nicht metallische Systeme als offenbart gelten.

Besonders vorteilhaft ist es erfindungsgemäß, wenn nach der Aufbringung der Funktionsschicht möglichst zeitnah, insbesondere innerhalb von 2 Stunden, vorzugsweise innerhalb von 30 Minuten, noch bevorzugter innerhalb von 10 Minuten, idealerweise innerhalb von 5 Minuten, die Kontaktierung der Festkörpersubstrate erfolgt. Durch diese Maßnahme werden etwaige unerwünschte Reaktionen wie Oxidierung der Funktionsschicht oder der Oberflächen der Festkörpersubstrate minimiert.

Erfindungsgemäß können Mittel zur Hemmung solcher Reaktionen der Funktionsschicht und/oder der Oberflächen der Festkörpersubstrate vor dem Kontaktieren der Kontaktflächen vorgesehen sein, insbesondere durch Passivierung der Oberflächen der Festkörpersubstrate, vorzugsweise durch Beaufschlagung mit N₂, Formiergas oder einer inerten Atmosphäre oder unter Vakuum oder durch Amorphisieren. Als besonders geeignet hat sich in diesem Zusammenhang eine Behandlung mit Plasma, welches Formiergas enthält, insbesondere überwiegend aus Formiergas besteht, erwiesen. Als Formiergas sind hier Gase zu verstehen, die mindestens 2%, besser 4%, idealerweise 10% oder 15% Wasserstoff enthalten. Der restliche Anteil der Mischung besteht aus einem inerten Gas wie beispielsweise Stickstoff oder Argon. Systeme mit inerter Atmosphäre oder Vakuum Atmosphäre lassen sich mit Vorzug als Systeme realisieren, bei denen der Transfer der Festkörpersubstrate von einer Prozesskammer zur nächsten Prozesskammer mittels eines Festkörpersubstrat Handhabungssystems geschieht, welches den Transfer der Festkörpersubstrate vollständig in einer kontrollierten, einstellbaren Atmosphäre, insbesondere einer Vakuum Atmosphäre durchführen kann. Derartige Systeme sind dem Fachmann bekannt.

Die Kontaktflächen zeigen üblicherweise eine Rauigkeit mit einer quadratischen Rauheit (R_{q}) von 0,2 nm auf. Dies entspricht Scheitel-ScheitelWerten der Oberflächen im Bereich von 1 nm. Diese empirischen Werte wurden mit der Atomic Force Microscopy (AFM) ermittelt.

Die erfindungsgemäße Reaktion ist geeignet, bei einer üblichen Waferfläche eines kreisförmigen Wafers mit einem Durchmesser von bis zu 450 mm die Funktionsschicht um 0,1 bis 10 nm, insbesondere 0,1 bis 1 nm, vorzugsweise um 0,1 bis 0,3 nm wachsen zu lassen, insbesondere lokal an Lücken zwischen den Kontaktflächen der Festkörpersubstrate.

Die (zusätzlich aufgebrachte) Funktionsschicht wird durch eines oder mehrere der nachfolgend genannten Verfahren aufgebracht:
- PECVD,
- LPCVD,
- Aufdampfen und
- Epitaxie.
- MOCVD
- Sputtern

Die Erfindung löst somit das Problem, die Oberflächen zweier zueinander in Kontakt gebrachter Festkörpersubstrate besser zu verschweißen, indem man an mindestens einer der Oberflächen eine Festkörperreaktion mit einer weiteren Materie, welche sich in der Funktionsschicht befindet, erzeugt, die zu einer Volumenausdehnung des entsprechenden Oberflächennahen Bereichs führt und damit die durch Oberflächenrauhigkeit vorhandenen Lücken oder Poren im Interface (Grenzfläche zwischen den in Kontakt gebrachten Festkörpersubstraten) verschließt. Es sei hierbei erwähnt, dass die beiden zueinander zu verschweißenden Festkörpersubstrate sich bereits größtenteils miteinander in Kontakt befinden. An den Kontaktstellen ist eine Volumenausdehnung normal auf die Festkörpersubstrate selbstverständlich nicht möglich, da das Material in dieser Richtung einer Dehnungsbehinderung unterliegt. Dennoch werden alle erfindungsgemäßen Methoden, welche den energetischen Zustand so stark erhöhen, dass das Material in die Poren ausweicht, explizit erwähnt. Entweder das Material dehnt sich durch die erfindungsgemäßen Methoden direkt in die Poren aus (beispielhaft, aber nicht einschränkend sei hier die Volumenausdehnung durch Mischkristallbildung oder einer Phasenumwandlung erwähnt) oder das Material kann sich durch die erfindungsgemäßen Methoden in eine Richtung nicht ausdehnen, da es einer Dehnungsbehinderung unterliegt, füllt allerdings die nahe gelegenen Poren aus, da es sich auf Grund des erhöhten energetischen Zustands plastisch verformt. Der Vollständigkeit halber sei erwähnt, dass eine plastische Verformung durch Versetzungen, Zwillingsbildung oder Diffusion erfolgen kann und im strengen physikalischen Sinne nicht mit einer Volumenausdehnung einhergeht. Im weiteren Verlauf der vorliegenden Beschreibung wird nicht mehr explizit zwischen Plastifizierung und (bleibender elastischer) Volumenausdehnung unterschieden. Der Terminus Volumenausdehnung soll für eine bleibende Vergrößerung und/oder Verformung eines Oberflächenteils stehen.

Die zweite Materie kann entweder als Schicht auf mindestens einem der beiden Substrate aufgebracht werden (Fig. 2), durch Korngrenzendiffusion zwischen die Körner einer ersten, insbesondere polykristallinen, Materie in das Volumen eindringen (Fig. 3), sich in einer Schichtstruktur mit Schichten der ersten Materie abwechseln (Fig. 4) oder durch mechanisches Legieren von Mikro- und/oder Nanoteilchen auf dem zweiten Festkörpersubstrat aufgebracht werden (Fig. 5).

Hierdurch werden höhere Bondstärken bei geringeren Temperaturen erreicht.

Gemäß einer vorteilhaften Ausführungsform der Erfindung ist vorgesehen, dass Ausbildung und/oder Verstärkung des permanenten Bonds durch Diffusion der zweiten Materie in die erste Materie, insbesondere unter Ausbildung einer Mischmaterie C erfolgt.

Gemäß einer weiteren, vorteilhaften Ausführungsform der Erfindung ist vorgesehen, dass die Ausbildung des permanenten Bonds bei einer Temperatur zwischen Raumtemperatur und 200 °C, insbesondere zwischen Raumtemperatur und 150°C, vorzugsweise zwischen Raumtemperatur und 100°C, noch bevorzugter zwischen Raumtemperatur und 50°C, insbesondere während maximal 12 Tagen, vorzugsweise maximal 1 Tag, noch bevorzugter maximal 1 Stunde, am besten maximal 15 Minuten, erfolgt.

Dabei ist es besonders vorteilhaft, wenn der irreversible Bond eine Bondstärke von größer 1,5 J/m², insbesondere größer 2 J/m², vorzugsweise größer 2,5 J/m² aufweist..

Die Bondstärke kann in besonders vorteilhafter Weise dadurch erhöht werden, dass bei der Festkörperdiffusion und/oder Phasenumwandlung eine Mischmaterie C mit einem größeren molaren Volumen als das molare Volumen der zweiten Materie und der ersten Materie gebildet wird. Hierdurch wird ein Anwachsen am zweiten Festkörpersubstrat beziehungsweise an der Funktionsschicht bewirkt, wodurch Lücken zwischen den Kontaktflächen durch die erfindungsgemäße Reaktion geschlossen werden können. Als Folge hieraus wird der Abstand zwischen den Kontaktflächen, also der mittlere Abstand, reduziert und Toträume minimiert.

Soweit vor der Aufbringung/Ausbildung der Funktionsschicht eine Plasmaaktivierung der Oberflächen der Festkörpersubstrate, insbesondere mit einer Aktivierungsfrequenz zwischen 10 und 600 kHz und/oder einer Leistungsdichte zwischen 0,075 und 0,2 Watt/cm² und/oder unter Druckbeaufschlagung mit einem Druck zwischen 0,1 und 0,6 mbar, erfolgt, werden zusätzliche Effekte wie die Glättung der Kontaktfläche bewirkt. Unter Druckbeaufschlagung meint man hier den Druck der Arbeitsatmosphäre während der Plasmaaktivierung.

Mit Vorteil ist in einer weiteren, vorteilhaften Ausführungsform der Erfindung vorgesehen, dass die Festkörperdiffusion und/oder Phasenumwandlung auf eine Oberflächenschicht (3o) des ersten Festkörpersubstrats (1) mit einer maximalen Ausgangsdicke D kleiner 1 µm, insbesondere kleiner 100nm, vorzugsweise kleiner 10nm, noch bevorzugter kleiner 1nm beschränkt ist.

Soweit das Zusammenpressen der Festkörpersubstrate bei einem Druck zwischen 0,1 MPa und 10 MPa erfolgt, können optimale Ergebnisse erzielt werden. Vorzugsweise liegt der Druck zwischen 0,1 und 10 MPa, noch bevorzugter zwischen 0,1 und 1 MPa, am Bevorzugtesten zwischen 0,1 und 0,3 MPa. Der Druck muss umso größer gewählt werden, je größer die Unebenheiten und je dünner die Schichten sind.

In vorteilhafter Weise ist gemäß einer Ausführungsform der Erfindung vorgesehen, dass die Ausbildung/Aufbringung der Funktionsschicht im Vakuum durchgeführt wird. Somit können Verunreinigungen der Funktionsschicht mit nicht erwünschten Materialien oder Verbindungen vermieden werden.

Besonders effektiv für den Verfahrensablauf ist es, wenn die Funktionsschicht mit Vorzug in einer mittleren Dicke R zwischen 0,1 nm und 25 nm, mit größerem Vorzug zwischen 0,1 nm und 15 nm, mit noch größerem Vorzug zwischen 0,1 nm und 10 nm, mit größtem Vorzug zwischen 0,1 nm und 5 nm ausgebildet wird.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

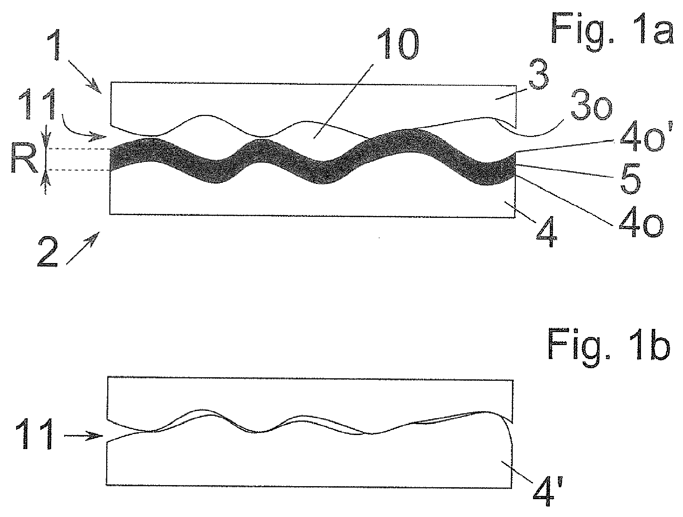

- Figur 1a: eine Darstellung eines ersten und zweiten erfindungsgemäßen Festkörpersubstrats in einem Zeitpunkt des erfindungsgemäßen Verfahrens unmittelbar nach der Kontaktierung des ersten Festkörpersubstrats mit dem zweiten Festkörpersubstrat,
- Figur 1b: permanent verbundene Festkörpersubstrate nach Durchführung des erfindungsgemäßen Verfahrens,

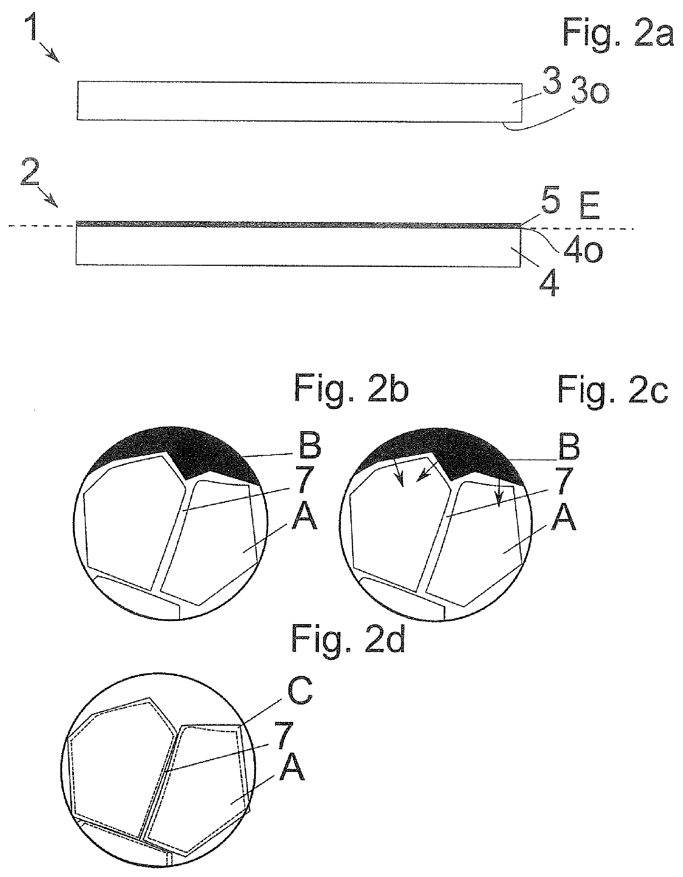

- Figur 2a: einen Schritt des erfindungsgemäßen Verfahrens zur Ausbildung/Aufbringung einer Funktionsschicht,
- Figur 2b bis 2d: Vergrößerungen der Grenzfläche zwischen dem zweitem Festkörpersubstrat und der Funktionsschicht gemäß Figur 2a,

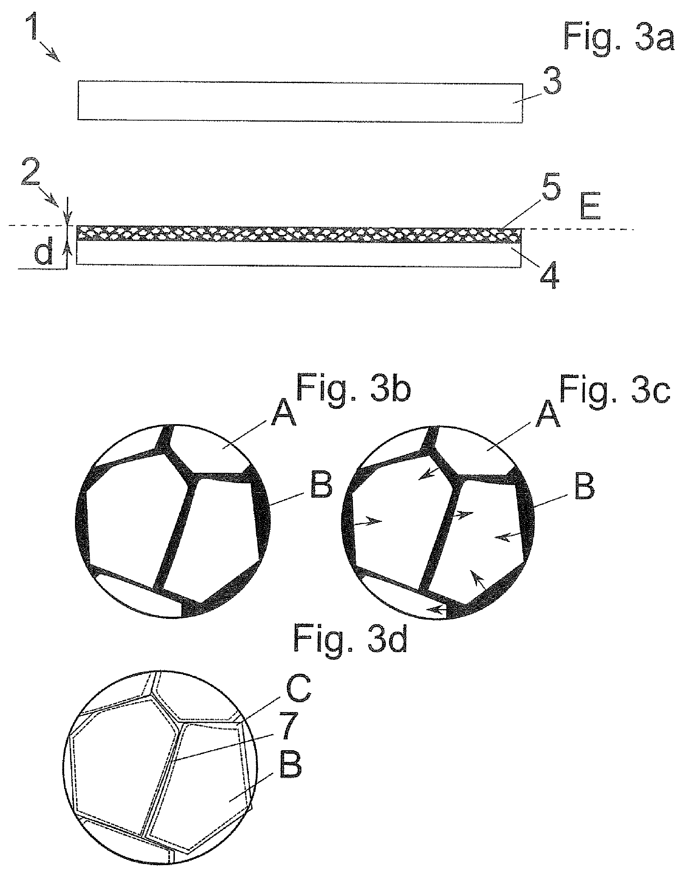

- Figur 3: einen alternativen Schritt des erfindungsgemäßen Verfahrens zur Ausbildung/Aufbringung einer Funktionsschicht,
- Figur 3b bis 3d: Vergrößerungen der Grenzfläche zwischen dem zweitem Festkörpersubstrat und der Funktionsschicht gemäß Figur 3a,

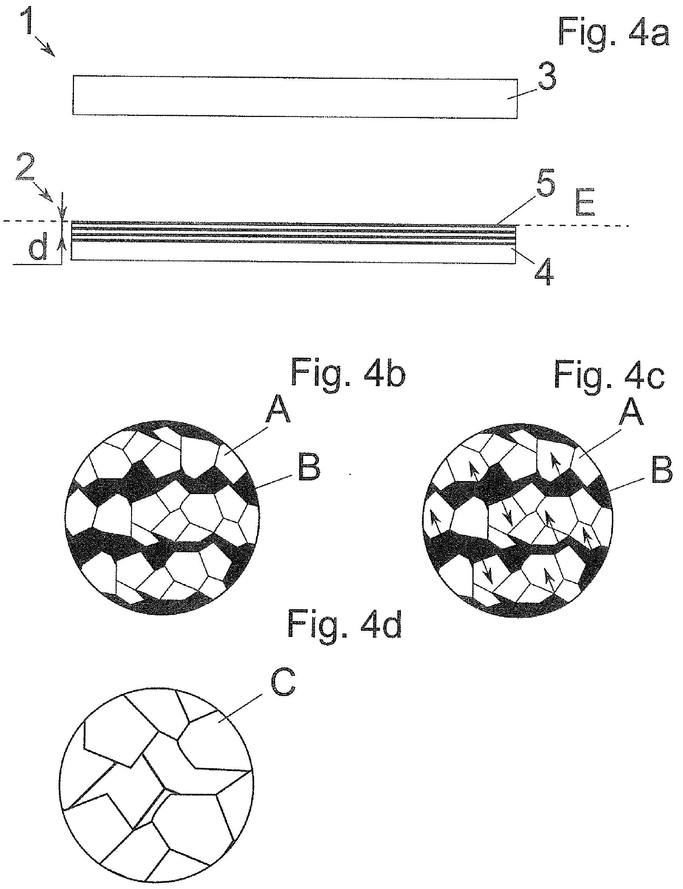

- Figur 4: einen alternativen Schritt des erfindungsgemäßen Verfahrens zur Ausbildung/Aufbringung einer Funktionsschicht,
- Figur 4b bis 4d: Vergrößerungen der Grenzfläche zwischen dem zweitem Festkörpersubstrat und der Funktionsschicht gemäß Figur 4a,

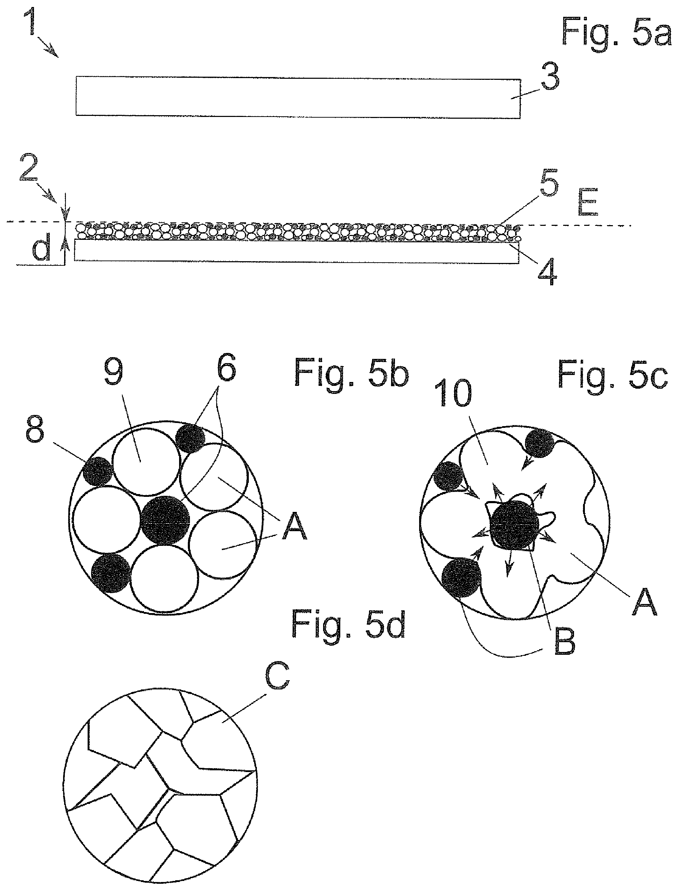

- Figur 5: einen alternativen Schritt des erfindungsgemäßen Verfahrens zur Ausbildung/Aufbringung einer Funktionsschicht,
- Figur 5b bis 5d: Vergrößerungen der Grenzfläche zwischen dem zweitem Festkörpersubstrat und der Funktionsschicht gemäß Figur 5a,

In den Figuren sind gleiche oder gleichwirkende Merkmale mit den gleichen Bezugszeichen gekennzeichnet.

Die Erfindung beschreibt ein Verfahren für eine Volumenexpansion oberflächennaher Bereiche (ausgehend von einer wirksamen Kontaktfläche 6 zwischen zu bondenden Festkörpersubstraten 1, 2), nämlich einer ersten Oberflächenschicht 3 des ersten Festkörpersubstrats 1 und/oder einer zweiten Oberflächenschicht 4 des zweiten Festkörpersubstrats 2 und/oder einer auf einer Oberflächenschicht 3, 4 vorgesehenen Funktionsschicht 5.

Die Volumenexpansion erfolgt durch eine Festkörperreaktion zwischen einer ersten Materie A und einer zweiten Materie B derart, dass Lücken 10 zwischen den kontaktierten Festkörpersubstraten 1, 2 entlang der wirksamen Kontaktfläche 6 (Interface 11) während einer zusätzlichen Druckbeaufschlagung in einem Bondprozess geschlossen werden. Die Lücken 10 sind unmittelbar nach der Kontaktierung der Festkörpersubstrate 1, 2 gemäß Figur 1a auf Grund deren Unebenheiten noch verhältnismäßig groß. Hierdurch ist die wirksame Kontaktfläche 6 entsprechend klein. In Figur 1b ist durch die Festkörperreaktion eine Volumenexpansion (Wachstum) bewirkt worden, so dass die Lücken 10 deutlich verkleinert wurden, insbesondere im Volumen mindestens um einen Faktor 2, vorzugsweise mindestens um einen Faktor 5, noch bevorzugter mindestens um einen Faktor 10. Entsprechend ist die wirksame Kontaktfläche 6 größer geworden.

Die Festkörperreaktion erfolgt dabei zwischen der ersten Materie A, welche vorzugsweise in der Funktionsschicht 5 vorliegt (> 50 Vol.-%), und der zweiten Materie eines der Festkörpersubstrate 1 und/oder 2, vorzugsweise zumindest des ersten, insbesondere oberen, Festkörpersubstrats 1.

Die Funktionsschicht 5 kann auf verschiedene, weiter unten beschriebene Verfahren erzeugt werden, wodurch eine geänderte zweite Oberflächenschicht 4' (da sie zusätzlich die Funktionsschicht 4 aufweist) mit einer neuen Oberfläche 4o' entsteht.

Erfingdungsgemäß ist es auch denkbar, dass die beiden Festkörpersubstrate 1, 2 aus zwei unterschiedlichen Materialien A₁ und A₂ bestehen. Ist das Material B so gewählt, dass eine Volumenexpansion bei Reaktion/Vermischung mit den beiden Materialien A₁ und A₂ erfolgt, ist die vorliegende Beschreibung hierauf übertragbar und ist von der Erfindung gedeckt. In einem bevorzugten Fall werden die Materialien A₁, A₂ und B als einphasige, Ein-Komponenten-Systeme gewählt. Alternativ sind A₁ und A₂ identisch, wobei insbesondere die Materien A und B aus der Gruppe der Metalle gewählt werden.

Die Oberflächenschichten 3 und/oder 4 sind jene Volumenbereiche unter den Oberflächen 3o, 4o der Substrate 1, 2, in welchen sich die erfindungsgemäße Festkörperreaktion zumindest überwiegend abspielt. Die Oberflächenschichten 3, 4 weisen insbesondere eine mittlere Dicke D kleiner als 1 µm, vorzugsweise kleiner als 100 nm, mit noch größerem Vorzug kleiner als 10 nm, mit größtem Vorzug kleiner als 1 nm, auf. Soweit die Materie B als polykristalline Materie ausgebildet ist, ist die mittlere Dicke D der Oberflächenschichten 3, 4 jeweils insbesondere maximal 50 mal so groß wie der mittlere Korndurchmesser der Materie B ((insbesondere der Einkristalle der Materie B) ist, mit größerem Vorzug maximal 20 mal so groß, mit noch größerem Vorzug maximal 10 mal so groß, mit größtem Vorzug maximal 5 mal so groß, mit allergrößtem Vorzug maximal 2 mal so groß. Die Figuren 1a und 1b sind somit stark vergrößert dargestellt.

Figur 1a zeigt den Zustand der Kontaktierung der Oberflächen 3o, 4o vor der Festkörperreaktion zwischen den beiden Materialien A und B, während Figur 1b die Oberflächenschichten 3, 4 nach der erfolgten Volumenexpansion und dem erfolgreichem Bondingprozess zeigt. Die Figuren zeigen die Änderung des Volumens und den damit eintretenden Lückenschluss entlang des Interface 11 beziehungsweise entlang der wirksamen Kontaktfläche 6, die durch den Lückenschluss größer wird. Durch die Vergrößerung der wirksamen Kontaktfläche 6 und durch die deutliche Reduzierung des mittleren Abstands zwischen den Oberflächen 3o, 4o wird die Bondkraft beträchtlich erhöht. Noch idealer werden die Löcher vollständig geschlossen, so dass zumindest später das Bondinterface nicht mehr erkennbar ist.

Die Materie B der Funktionsschicht wird durch die Festkörperreaktion in der Oberflächenschicht 3 und/oder 4 zumindest teilweise verbraucht. Die mittlere Dicke R der Funktionsschicht 5 ist abhängig von den unterschiedlichsten Parametern (Temperatur, Wahl der Materien A und B, Bonddruck, zeitlicher Ablauf, Diffusionsgeschwindigkeiten). Bei den beiden Materien A und B kann es sich um Metalle, Kunststoffe, Keramiken oder Halbleiter handeln, wobei Metalle bevorzugt sind. Die Festkörpersubstrate 1, 2 können insbesondere als Wafer ausgebildet sein.

Die unterschiedlichen erfindungsgemäßen Ausführungsformen der Erfindung werden nun im Einzelnen vorgestellt. Dabei werden die Materien A und B als einphasige Ein-Komponenten-Materien ausgewählt. Die Materie A und oder die Materie B bestehen vorzugsweise jeweils aus einem einzigen beziehungsweise einheitlichen Material. In den gezeigten Ausführungsformen wird die Materie B nur auf dem zweiten Festkörpersubstrat 2 aufgebracht.

Eine erfindungsgemäße Ausführungsform besteht darin, die Volumenausdehnung durch die Lösung der Komponente B in A zu realisieren. Beispielhaft ist für diese erfindungsgemäße Ausführungsform das Kupfer-Zinn System genannt werden. Als Stoff/Material für die Materie A wird das Metall Kupfer ausgewählt und als Materie B wird das Metall Zinn ausgewählt.

Die Ausdehnung des Kupfers, welche zum Schließen der Lücken 10 im Interface 11 beiträgt, erfolgt durch die Bildung eines Kupfermischkristalls C. Ein Mischkristall C ist eine kristalline Phase, die aus mindestens zwei verschiedenen Materien, hier den Materien A und B, besteht, die innerhalb eines Konzentrationsbereichs vollständig miteinander mischbar sind. Gemäß Phasendiagramm Cu-Sn besitzt Kupfer bei Raumtemperatur eine Löslichkeit für Zinn. Die Löslichkeit nimmt mit steigender Temperatur zu und hat ein Maximum bei etwa 850K. Zinn hingegen besitzt eine verschwindend geringe Löslichkeit für Kupfer bis zum Schmelzpunkt. Auf Grund des Zusammenhangs zwischen dem Volumen und der Konzentration jedes Mischkristalls (Vegard'sche Regel) wird in der einfachsten Ausführungsform Zinn als Materie B auf der Oberflächenschicht 4 des zweiten Festkörpersubstrats 2 (zumindest Oberflächenschicht 4 aus Kupfer als erste Materie A) abgeschieden (Figur 2a). Die Verfahrensparameter werden so gewählt, dass die zweite Materie B (Zinn) zu diesem Zeitpunkt noch keine Verbindung mit der ersten Materie (Kupfer) eingeht. Die Menge des Zinns ist dabei so bemessen, dass sich bei einer später stattfindenden Diffusion des Zinns in das Kupfer (Fig. 2c) vorzugsweise niemals eine intermetallische Phase bildet. Anders ausgedrückt: Die Oberflächenschicht 4 wird an keiner Stelle so mit Zinn gesättigt, dass sich intermetallische Phasen bilden können. Für das binäre Phasensystem Cu-Sn darf laut Phasendiagramm bei Raumtemperatur eine Molkonzentration für Sn in Cu von ca. 0,01 (entspricht ca. 14 Gew.-% Sn) nicht überschritten werden. Damit wird eine Bildung der Cu₃Sn Phase unterbunden, da die Löslichkeitsgrenze des Kupfers für das Sn noch nicht überschritten wurde. Für steigende Temperatur wird die Löslichkeit von Sn in Cu entsprechend größer.

Sehr wohl verändert sich allerdings durch die Aufnahme der zweiten Materie B (Zinn) in die erste Materie A (Kupfer) das Volumen des Kupfermischkristalls. Da Zinn einen größeren Atomradius als Kupfer besitzt, steigt das Volumen des Kupfermischkristalls C mit steigendem Zinngehalt (Figur 2d). Der Beginn vom Diffusionsprozess des Zinns in das Kupfer wird vorzugsweise auf Grund der Prozessparameter gesteuert, insbesondere durch Temperaturerhöhung, da die Diffusionskonstanten explizit von der Temperatur abhängen.

Bei der hier vorgestellten Ausführungsform erfolgt das permanente Bonden unterhalb von 200 °C. Die Temperatur, bei welcher eine nennenswerte Diffusion des Zinns ins Kupfer beginnt, liegt bei den erfindungsgemäß gewählten anderen Prozessparametern zwischen Raumtemperatur (RT) und 200 °C, mit größerem Vorzug zwischen RT und 150 °C, mit noch größerem Vorzug zwischen RT und 100 °C mit allergrößtem Vorzug zwischen RT und 50 °C. Für einen Fachmann auf dem Gebiet ist klar, dass jeder Parameter, welcher die gewünschte Diffusion steuern kann, verwendet werden kann, um den gewünschten Effekt zu erzielen.

Durch das gezielte Einsetzen der Diffusion nimmt das Kupfer Zinn auf, vergrößert damit sein Volumen und kann so die Lücken 10 im Interface 11 schließen. Bei Metallen kommt ergänzend hinzu, dass die hohe Plastizität den Schließvorgang der Lücken 10 begünstigt.

Erfindungsgemäß ist es außerdem vorgesehen zu verhindern, dass die Löslichkeitsgrenze der ersten Materie (Kupfer) für die zweite Materie (Zinn) überschritten wird, so dass Ausscheidung von intermetallischen Phasen möglichst weitgehend, insbesondere vollständig, vermieden wird. Soweit Materien A und B gewählt werden, die im festen Zustand vollständig mischbar sind, kann die Löslichkeitsgrenze erfindungsgemäß außer Betracht bleiben.

Die Abscheidung der zweiten Materie B (Zinn) auf der ersten Materie A (Kupfer) wird erfindungsgemäß so durchgeführt, dass die Löslichkeitsgrenze des Kupfers für das Zinn bei der entsprechenden Temperatur an möglichst wenigen, mit noch größerem Vorzug an keinem Ort, in der Oberflächenschicht 4 überschritten wird (siehe Figur 2b). Die Bestandteile (Ein- oder Mehrkristalle) der Materie A sind schematisiert dargestellt. Gemäß Figur 2c diffundiert die zweite Materie B (Zinn) nur an der Grenzfläche zwischen der Funktionsschicht 5 und der Oberfläche 4o vor Aufbringung der Funktionsschicht 4 in die erste Materie A hinein, was insbesondere bei Einkristallen als erste Materie A die bevorzugte Ausführungsform ist. Das Anwachsen der ersten Materie A in Form der Mischmaterie C ist schematisch in Figur 2d gezeigt. Zwischen Bestandteilen der ersten Materie A vorliegende Zwischenräume 7 (soweit vorhanden) werden kleiner, so dass eine Bestrebung der Bestandteile erreicht wird, sich in Richtung der Kontaktfläche 6 auszudehnen. Dabei expandiert die Mischmaterie C wegen des an der wirksamen Kontaktfläche 6 anliegenden Drucks des gegenüberliegenden Festkörpersubstrats 1 überwiegend im Bereich der Lücken 10.

Um die Bildung intermetallischer Phasen weitergehend zu verhindern, ist gemäß einer weiteren Ausführung vorgesehen, dass die zweite Materie (Zinn) als Funktionsschicht 5 nicht nur an der Oberfläche 4o der ersten Materie (Kupfer) abgeschieden wird (Fig. 2), bevor der eigentliche Diffusionsprozess startet, sondern in die Oberflächenschicht 4 innerhalb der Schichtdicke d (Fig. 3) einzubringen, ohne das Zinn dabei in Lösung mit dem Kupfer gehen zu lassen.

Hierzu wird die zweite Materie B (Zinn), insbesondere über Korngrenzendiffusionsprozesse in größere Tiefen der polykristallinen ersten Materie A (Kupfer) gelangen, mit Vorzug noch nicht in das Volumen der Körner übergehen, höchstens am äußeren Rand der Körner geringfügig in die Tiefe eindringen und erst beim entscheidenden Bondingprozess wirklich in das Volumen eindringen, um die Volumenvergrößerung hervorzurufen (Fig. 3). Die polykristalline Mikrostruktur des ersten Materials A ist polykristallin, besteht also aus einzelnen Körnern, welche durch Zwischenräume 7 (hier: Korngrenzen) voneinander getrennt sind. Die Zwischenräume 7 sind bei polykristalliner Mikrostruktur zweidimensionale Gitterbaufehler, in die Atome unterschiedlicher Spezies vordringen können. Mit Vorzug wird die Mikrostruktur mindestens einer der zu bondenden Festkörpersubstrate 1, 2 so hergestellt, dass sich die zweite Materie (Zinn) nicht nur an der Oberfläche 4o, sondern auch in der Oberflächenschicht 4 befindet, ohne sich dabei im Kupfer zu lösen. Somit ist die Funktionsschicht 5 bei dieser Ausführungsform zumindest teilweise identisch mit der Oberflächenschicht 4.

Eine erfindungsgemäße Ausführung besteht daher darin, den Unterschied zwischen Korngrenzen- und Volumendiffusion zu benutzen, um das Zinn in die Volumentiefe der Kupferschicht zu befördern, ohne Konzentrationserhöhungen in den Kupferkörnern zu erhalten (siehe insbesondere Fig. 3). Die Prozessparameter werden dabei so gewählt, dass die Korngrenzendiffusion vor einer Volumendiffusion erfolgt, da es für die diffundierende Spezies - im Ausführungsbeispiel Zinn - viel leichter ist, sich in den weiträumigen Korngrenzen fortzubewegen, als durch das enge Gitter des Bulks (der Kupferkörner). Entscheidend ist dabei die Berücksichtigung des Diffusionskoeffizienten. Der Diffusionskoeffizient für die Korngrenzendiffusion ist für eine vorgegebene Temperatur größer als der Diffusionskoeffizient für die entsprechende Volumendiffusion. Dabei ist auch das Korngrenzenoberflächen- zu Kornvolurnenverhältnis zu berücksichtigen, da bei höherem Verhältnis pro Volumeneinheit entsprechend mehr Korngrenzen vorhanden sind. Mit besonderem Vorzug ist der Aggregatzustand der Phase, welche sich entlang der Korngrenzen bewegt, flüssig. Erfindungsgemäß bieten sich daher Materialien an, die einen sehr niedrigen Schmelzpunkt besitzen. Die Diffusionsgeschwindigkeit der flüssigen Phase entlang der Korngrenze ist dementsprechend hoch.

Somit diffundiert die zweite Materie B hier nicht nur an der Grenzfläche zwischen der Funktionsschicht 5 und der Oberfläche 4o vor Aufbringung der Funktionsschicht 4 in die erste Materie A hinein, auf Grund der Durchdringung der Oberflächenschicht 4 von quasi allen Seiten jedes Bestandteiles (Kupferkorns) der ersten Materie.

Eine weitere Ausführung besteht im Abscheiden einer Schichtstruktur (Figur 4). Die Komponenten Kupfer und Zinn werden dabei durch an sich bekannte Abscheidemethoden schichtweise, vorzugsweise abwechselnd Materie A und B, abgeschieden. Auf diese Weise wird eine "Zwischenlösung" zu der reinen "Oberflächenlösung" gemäß Figur 2 und der "Mischlösung" gemäß Figur 3 vorgesehen, bei der mehrere Grenzflächen zur Diffusion der zweiten Materie B in die erste Materie A vorgesehen sind.

Gemäß einer weiteren Ausführungsform der Erfindung ist vorgesehen, die erste Materie A (Kupfer) und die zweite Materie B (Zinn) als Mikro- und/oder Nanopartikeln 8, 9 aus einer Lösung auf der Oberfläche 4o abzuscheiden, also eine mechanische Legierung auf das zweite Festkörpersubstrat 2 aufzubringen (Figur 5). Für sphärische Partikel kann bei bekannter Dichte des Kupfers und des Zinns, und den bekannten mittleren Kugelradien der Kupfer und Zinn-Partikel das benötigte Mischungsverhältnis für den Kupfer-Zinn Mischkristall exakt berechnet werden. Bei Partikeln mit einer anderen Form sind entsprechend angepasste Formeln zu verwenden.

Beim Bondingprozess entstehen bei dieser Ausführungsform mit Vorzug Sinterbrücken, welche die Mikro- und/oder Nanopartikel 9 miteinander zu einer Sintermatrix 10 verschweißen. Gleichzeitig erfolgt eine Diffusion der zweiten Komponente B in die Sintermatrix 10. Da die Mikro- und/oder Nanopartikel 8 der zweiten Materie B durch die mechanische Legierung statistisch gleichverteilt in der Sintermatrix 10 der ersten Materie A vorliegen, ist eine optimale, gleichmäßige Verteilung der zweiten Materie B, über einen scharf abgrenzbaren Volumenbereich möglich. Die Materien A und B sind erfindungsgemäß so gewählt, dass das Volumen des neu gebildeten Mischkristalls C (über den Sinterprozess) größer ist als das Volumen der mechanischen Legierung vor dem Bondingprozess.

Es ist dabei zu berücksichtigen, dass mechanische Legierungen durch Mikro- und/oder Nanopartikel 8, 9 eine im Allgemeinen geringere Dichte aufweisen als Bulkmaterialien, da sich zwischen den Mikro- und/oder Nanopartikeln 8, 9 sehr viel Leerraum befindet, welcher erst nach durch den Sinterprozess geschlossen wird. Im optimalsten Fall wird der Leerraum vollständig abgebaut. Mit Vorzug ist das Gefüge nach dem Bondingprozess wieder ein polykristallines Gefüge mit einem Mischkristall.

Erfindungsgemäß ist auch eine bevorzugte Ausführung, bei der Kupfer und Zinn durch PVD und/oder CVD Prozesse direkt mit der vorgegebenen Konzentration auf das zweite Festkörpersubstrat abgeschieden werden. Hierdurch wird unmittelbar die Mischmaterie C (Mischkristall) hergestellt. Eine zu große Zinnkonzentration würde zu intermetallischen Phasen führen.

In einer weiteren Ausführungsform wird die Volumenvergrößerung durch die Bildung einer vollständig neuen Phase realisiert, also eine Phasenumwandlung statt einer Diffusion (auch in Kombination erfindungsgemäß denkbar). Die Reaktion der zweiten Materie B mit der ersten Materie A führt dabei zu einer beliebigen Verbindung AxBy, deren molares Volumen größer ist, als die Summe der beiden molaren Volumina der Komponenten A und B. Die Phasenumwandlung soll durch Auswahl entsprechender Prozessparameter gesteuert ablaufen. Daher sollte die abgeschiedene Komponente B mit Vorzug erst dann mit der Komponente A reagieren, wenn das erwünscht ist, also während des Bondvorgangs. Die Volumenvergrößerung wird also durch eine Phasenumwandlung hervorgerufen.

In einer speziellen Ausführungsform der Phasenumwandlung wird die Volumenvergrößerung durch eine martensitische Umwandlung erzeugt. Eine martensitische Umwandlung ist eine diffusionslose Phasenumwandlung, welche durch einen Umklappprozess des Gitters erfolgt. Der Umklappprozess erfolgt nur durch eine sehr rasche Temperaturabnahme. Ein weiterer Vorteil eines Martensits besteht in der oft extrem hohen Versetzungsdichte, welche durch die Scherprozesse der Martensitbildung hervorgerufen werden. Beim Bondprozess würden die Poren mittels der Volumenausdehnung während der martensitischen Umwandlung geschlossen werden aber gleichzeitig würde sich das Gefüge extrem verfestigen, d.h. seine Versetzungsdichte würde steigen. Die Versetzungsdichte kann in einigen Martensiten möglicherweise als Hilfe für einen späteren Rekristallisationsprozess genutzt werden.

In einer weiteren Ausführungsform wird die Volumenvergrößerung während des Bondvorganges in den oberflächennahen Bereichen durch die spinodale Entmischung einer Legierung hervorgerufen. Eine spinodale Entmischung ist eine spontane Separation eines homogenen Gefüges in mindestens zwei Phasen durch das Überschreiten eines kritischen Parameters, vorzugsweise der kritischen Temperatur. Das homogene Gefüge wurde durch einen Abkühlvorgang eines Mehrkomponentensystems erzeugt, dessen Konzentration sich innerhalb der Spinodalen befindet. Dem Fachmann ist bekannt, welche Legierungen sich spinodal entmischen können, wie solche Legierungen hergestellt und wärmebehandelt werden müssen. Insbesondere werden Legierungen mit spinodaler Entmischung ausgewählt, deren Entmischungsvorgang zu einer Volumenexpansion führt.

### Bezugszeichenliste

- 1: erstes Festkörpersubstrat
- 2: zweites Festkörpersubstrat
- 3: erste Oberflächenschicht
- 3o: Oberfläche
- 4, 4': zweite Oberflächenschicht
- 4o, 4o': Oberfläche
- 5, 5': Funktionsschicht
- 6: wirksame Kontaktfläche
- 7: Zwischenräume
- 8: Mikro- und/oder Nanopartikeln
- 9: Mikro- und/oder Nanopartikeln
- 10: Sintermatrix
- 11: Interface
- A: Erste Materie
- B: zweite Materie
- C: Mischmaterie
- R: mittlere Dicke
- D: mittlere Dicke

## Patentansprüche

1. Verfahren zum permanenten Bonden eines ersten Festkörpersubstrats (1) mit einem eine erste Materie (A) enthaltenden zweiten Festkörpersubstrat (2) mit folgendem Ablauf:
-- Aufbringung und/oder Ausbildung einer eine zweite Materie (B) enthaltende Funktionsschicht (5) auf das zweite Festkörpersubstrat (2), wobei die Funktionsschicht (5) vor der Ausbildung des permanenten Bonds eine mittlere Dicke (R) zwischen 0,1 nm und 25 nm aufweist,
-- Kontaktieren des ersten Festkörpersubstrats (1) mit dem zweiten Festkörpersubstrat (2) an der Funktionsschicht (5),
-- Zusammenpressen der Festkörpersubstrate (1, 2),
wobei nach dem Kontaktieren eine Reaktion der zweiten Materie (B)
mit der ersten Materie (A) derart erfolgt, dass durch Unebenheiten der Oberflächen der Festkörpersubstrate (1, 2) vorhandene Lücken verschlossen werden.

2. Verfahren nach Anspruch 1, bei dem eine Diffusion der zweiten Materie (B) in die erste Materie (A), insbesondere unter Ausbildung einer Mischmaterie (C), bevorzugt eines Mischkristalls (C), erfolgt.

3. Verfahren nach einem der vorhergehenden Ansprüche, bei dem die Ausbildung des permanenten Bonds bei einer Temperatur zwischen Raumtemperatur und 500°C, insbesondere zwischen Raumtemperatur und 200 °C, vorzugsweise zwischen Raumtemperatur und 150°C, noch bevorzugter zwischen Raumtemperatur und 100°C, am bevorzugtesten zwischen Raumtemperatur und 50°C, insbesondere während maximal 12 Tagen, vorzugsweise maximal 1 Tag, noch bevorzugter maximal 1 Stunde, am besten maximal 15 Minuten, erfolgt.

4. Verfahren nach einem der vorhergehenden Ansprüche, bei dem der permanente Bond eine Bondstärke von größer 1,5 J/m², insbesondere größer 2 J/m², vorzugsweise größer 2,5 J/m² aufweist.

5. Verfahren nach einem der vorhergehenden Ansprüche, bei dem bei der Reaktion, insbesondere bei einer Festkörperdiffusion und/oder Phasenumwandlung, eine Mischmaterie (C) mit einem größeren molaren Volumen als das molare Volumen der zweiten Materie (B) und der ersten Materie (A) gebildet wird.

6. Verfahren nach einem der vorhergehenden Ansprüche, bei dem vor und/oder nach der Aufbringung/Ausbildung der Funktionsschicht (5) eine Plasmaaktivierung der Oberflächen der Festkörpersubstrate (1, 2) erfolgt.

7. Verfahren nach einem der vorhergehenden Ansprüche, bei dem die Reaktion, insbesondere eine Festkörperdiffusion und/oder Phasenumwandlung, auf eine Oberflächenschicht des zweiten Festkörpersubstrats (2) mit einer maximalen Ausgangsdicke (D) kleiner µm, insbesondere kleiner 100nm, vorzugsweise kleiner 10nm, noch bevorzugter kleiner 1nm beschränkt wird.

8. Verfahren nach einem der vorhergehenden Ansprüche, bei dem das Zusammenpressen bei einem Druck zwischen 0,1 und 10 MPa stattfindet.

9. Verfahren nach einem der vorhergehenden Ansprüche, bei dem die Funktionsschicht (5) vor der Ausbildung des permanenten Bonds eine mittlere Dicke (R) zwischen 0,1 nm und 10 nm aufweist.

10. Verfahren nach einem der vorhergehenden Ansprüche, bei dem die Löslichkeitsgrenze des ersten Materials (A) für das zweite Material (B) während der Ausbildung des permanenten Bonds zumindest nur geringfügig, insbesondere an keiner Stelle einer Festkörperdiffusion und/oder Phasenumwandlung, überschritten wird.

11. Verfahren nach einem der vorhergehenden Ansprüche, bei dem eine Festkörperdiffusion zumindest überwiegend als Korngrenzendiffusion erfolgt.

12. Verfahren nach einem der vorhergehenden Ansprüche, bei dem jeweils eine Funktionsschicht (5) auf jedem Festkörpersubstrat (1, 2) aufgebracht und/oder ausgebildet wird.

13. Verfahren nach einem der vorhergehenden Ansprüche, bei dem als die Reaktion eine Festkörperdiffusion und/oder eine Phasenumwandlung erfolgt.

14. Verfahren nach einem der vorhergehenden Ansprüche, bei dem durch die Reaktion eine Verformung mindestens einer der Kontaktflächen erfolgt.

15. Verfahren nach einem der vorhergehenden Ansprüche, bei dem durch die Reaktion eine Volumenausdehnung erfolgt.
